# EUROPEAN PATENT SPECIFICATION

(11) **EP 1 964 181 B1**
(45) Date of publication and mention of the grant of the patent: **14.08.2019**
(21) Application number: 06830738.8
(22) Date of filing: 20.12.2006
(51) Int. Cl.: H01L 31/048, H01L 31/046

(54) **PHOTOVOLTAIC DEVICE AND METHOD OF ENCAPSULATING**
PHOTOVOLTAISCHES BAUELEMENT UND VERKAPSELUNGSVERFAHREN
DISPOSITIF PHOTOVOLTAÏQUE ET PROCÉDÉ D'ENCAPSULATION

(30) Priority: 22.12.2005 US 4668 P
(43) Date of publication of application: 03.09.2008
(73) Proprietor: (CNBM) Bengbu Design & Research Institute for Glass Industry Co., Ltd., Bengbu (CN)
(72) Inventor: CALWER, Hermann, 81739 Munich (DE); PROBST, Volker, 14089 Berlin (DE); WIETING, Robert D, Simi Valley, California 93065 (US)
(74) Representative: Gebauer, Dieter Edmund
(86) International application number: PCT/EP2006/069965
(87) International publication number: WO 2007/071703

(56) References cited:
- EP-A- 0 896 371
- EP-A1- 0 500 066
- JP-A- 55 029 185
- US-A- 3 957 537
- US-A- 4 104 083
- US-A- 4 110 122
- US-A- 4 239 555
- US-A- 4 283 589
- US-A- 5 217 540
- US-A- 5 252 139
- US-A- 5 741 370
- US-A- 5 994 641
- US-A1- 2002 148 496
- PATENT ABSTRACTS OF JAPAN vol. 009, no. 318 (E-366), 13 December 1985 (1985-12-13) -& JP 60 150659 A (MATSUSHITA DENKI SANGYO KK), 8 August 1985 (1985-08-08)
- PATENT ABSTRACTS OF JAPAN vol. 017, no. 528 (E-1437), 22 September 1993 (1993-09-22) -& JP 05 145101 A (TONEN CORP), 11 June 1993 (1993-06-11)

## Description

### Field of the invention

The present invention relates to a photovoltaic device, to a method of encapsulating a photovoltaic device, and to the use of a cover for encapsulating a photovoltaic device.

### Background of the invention

Solar cells are typically formed of a photovoltaic layer arranged on a substrate, and encapsulated for protection against environmental influences. On the light-receiving side a cover is provided, typically of a transparent material, in particular hardened glass is often used.

Thin-film solar cells are typically arranged on a glass substrate. In thin-film solar cells the photovoltaic layer is a thin film comprised of one or more thin layers forming a photoactive pn-junction, and including necessary electrodes. A particular thin film solar cell is a so-called chalkopyrite or I-III-VI solar cells. Another thin-film solar cell is an amorphous silicon solar cell.

The photovoltaic layer of a solar cell does not normally cover the entire substrate area. In particular, in a border area along the circumference of the substrate no photovoltaic layer is arranged, or it is removed from this area before encapsulation e.g. by laser cleaning in this area.

For encapsulation, a polymeric sealant material such as a polymer tape can be arranged along the circumference of the substrate, and the cover is laminated to the substrate with the photoactive layer.

A plurality of solar cells can be arranged under a common cover to form a solar module. A solar cell or solar module can be arranged in a frame. The expression photovoltaic device will be used in the description and in the claims to refer generally to a solar cell, a solar module or other devices generating photovoltaic energy.

The encapsulation is to protect the photovoltaic device from environmental influences, such as mechanical impact, temperature fluctuations, moisture. Photovoltaic devices have to pass qualification test such as the wet leakage current test of IEC 61646. Commercial photovoltaic devices are typically sold with warranty periods of 10 to 25 years, so the requirements for long-term durability are high. Document EP 0896 371 A1 discloses a photovoltaic device as known in the prior art, comprising a thin-film photovoltaic layer placed between a substrate and a transparent cover plate.

In the article "CIS THIN FILM MANUFACTURING AT SHELL SOLAR: PRACTICAL TECHNIQUES IN VOLUME MANUFACTURING", Robert Wieting et. al, Proceedings of the 31st IEEE Photovoltaics specialist Conference held in Orlando, Florida, 3-7 January 2005, it is stated that the cover glass can optionally be screen printed on the interior surface with a black frit perimeter like those used on automobile windshields to provide an even more aesthetically pleasing appearance.

It is an object of the present invention to improve the stability, in particular long-term durability, of encapsulated photovoltaic devices, in particular of chalkopyrite photovoltaic devices.

### Summary of the Invention

The present invention is defined in claims 1 and 9. The invention provides a photovoltaic device comprising a thin-film photovoltaic layer between a substrate and a cover plate, which cover plate is transparent in an area above the photovoltaic layer, wherein the cover plate overlaps the photovoltaic layer, and wherein the cover plate, in an area adjacent to the photovoltaic layer, is opaque, wherein the cover plate is coated in the opaque area, on at least one side facing towards, or away from, the substrate, or has a modified body so as to be opaque in that area, wherein the opaque area has a colour adjusted to the colour of the photovoltaic layer, wherein the opaque area extends from just above the edge of the photovoltaic layer to the edge of the cover plate or below the rim of a frame.

Applicant has realized that an opaque cover plate in areas adjacent the photovoltaic layer helps to improve the stability of encapsulated photovoltaic devices. A particular problem that can be handled in this way is thermal stress. The photovoltaic layer is typically dark, and in the case of chalkopyrite photovoltaic devices, substantially black. Areas not covered by the photovoltaic layer are normally lighter, or transparent. Under irradiation of sunlight, therefore, the photovoltaic device area and the remaining area are differently heated, leading to thermal stress. This is particularly problematic in a border area of a fragile substrate. For thin film-photovoltaic devices often unhardened float glass is used as substrate. Float glass is often cut to size such that microcracks are present around the circumference. Thermal stress in the border area can result in macroscopic cracking of the substrate. The opaque cover alleviates this problem, since thermal stress inhomogeneity is reduced due to the absorption of sunlight also in areas adjacent the area of the photovoltaic layer.

A further problem that can be alleviated by the invention is light (including ultra-violet [=UV] light) degradation of materials, in particular of polymeric materials, more in particular along the edges of a solar cell or module. Such polymeric materials can be a lamination foil such as of EVA (ethylene vinyl acetate) or PVB (polyvinyl butyral), applied between the photovoltaic layer and the cover plate, and in particular polymeric sealants which can for example be applied around a circumference of the substrate, in order to seal against ingress of moisture. Many polymers degrade over time, and degradation is often driven by light and in particular UV irradiation. The opaque cover can block light and in particular UV irradiation to the polymer, so that the degradation underneath the opaque area, preferably along the edges (edge seal and/or portion of the laminate foil in that area), is retarded or prevented.

Suitably the opaque area includes substantially all area that can receive light and under which area no photovoltaic layer is present. This maximises the beneficial effects described above. Suitably also, the opaque area only minimally overlaps, within practically possible production tolerances, the photovoltaic layer, to minimize any loss of photovoltaic device efficiency.

The opaque area can be provided by coating the cover plate, e.g. by painting, or screen printing, suitably followed by a heat treatment.

The cover plate is typically flat and has a thickness in the range of 0.5-10 mm, preferably 1-5 mm, and can be of any material that has sufficient transparency above the photovoltaic layer. Suitably the cover plate is a cover glass, preferably hardened glass.

In an embodiment practically very relevant for thin-film photovoltaic devices such as chalkopyrite cells, the substrate is of a fragile material such as unhardened glass. It is in this case particularly beneficial to cover all area outside the thin film with an opaque cover, to prevent cracking due to thermal stress.

The opaque area has a colour adjusted to the colour of the photovoltaic layer. In particular the opaque area can be black in the case of a black photovoltaic layer. In other words, suitably the energy absorption transformed into heat, per unit area from incident light in the opaque area substantially matches the energy absorption transformed into heat in the area of the photovoltaic layer.

Suitably, the opaque area also substantially blocks UV radiation. This is particularly beneficial if a polymeric material that can degrade under light, in particular UV, irradiation, in particular a polymeric sealant, is present underneath the opaque area. Substantially blocking light, in particular UV, radiation means a transmissivity for light, in particular UV, radiation of less than 20%, preferably less than 10%, more preferably less than 5%, most preferably substantially zero transmissivity, respectively for light or at least UV.

The invention further provides a method of encapsulating a photovoltaic device, comprising the steps of
- providing a substrate, having an area, with a thin-film photovoltaic layer on a partial area of the substrate,
- providing a cover plate having a transparent area and an opaque area adjacent the transparent area;
- arranging the cover plate over the photovoltaic layer, so that the opaque area covers at least part of the substrate area outside the partial area on which the photovoltaic layer is arranged, wherein the opaque area has a colour adjusted to the colour of the photovoltaic layer, wherein the opaque are extends from just above the edge of the photovoltaic layer to the edge of the cover plate or below the rim of a frame.

In a particular embodiment a polymeric sealant material is arranged on the substrate, and the cover is arranged such that the polymeric sealant material is covered by the opaque area. In many practical cases, in particular where the sealant runs only around the circumference of the substrate, the opaque area suitably surrounds the transparent area. It is possible however that the sealant material is also arranged on areas other than the circumference of the substrate, e.g. in the case that a plurality of photovoltaic devices is arranged in one module and covered by one cover.

The invention further provides the use of a cover plate provided with a transparent area and an opaque and UV absorbing area adjacent to the transparent area for encapsulating a photovoltaic device comprising a thin-film photovoltaic layer arranged on a substrate, and for protecting UV degradable material, in particular polymeric material, more in particular polymeric sealant material, present adjacent the photovoltaic layer from UV induced degradation.

The invention moreover provides the use of a cover plate provided with a transparent area and an opaque area adjacent the transparent area for encapsulating a photovoltaic device comprising a thin-film photovoltaic layer arranged on a substrate that is larger than the photovoltaic layer, and for protecting the encapsulated photovoltaic device from thermal stress during due to light irradiation.

Suitable and preferred embodiments discussed with reference to the photovoltaic device of the invention are likewise suitable for special embodiments of the method and the uses of the present invention.

### Brief description of the Drawings

The invention will now be described in more detail and with reference to the accompanying drawings, wherein
Figure 1 shows schematically a first embodiment of the invention in cross-section though an edge part;
Figure 2 shows schematically a second embodiment of the invention in cross-section through an edge part; and
Figure 3 shows schematically a third embodiment in top view;
Figure 4 shows schematically a view along line IV-IV of a Figure 3.

Where the same reference numerals are used in different Figures, they refer to the same or similar objects.

### Detailed Description of the Invention

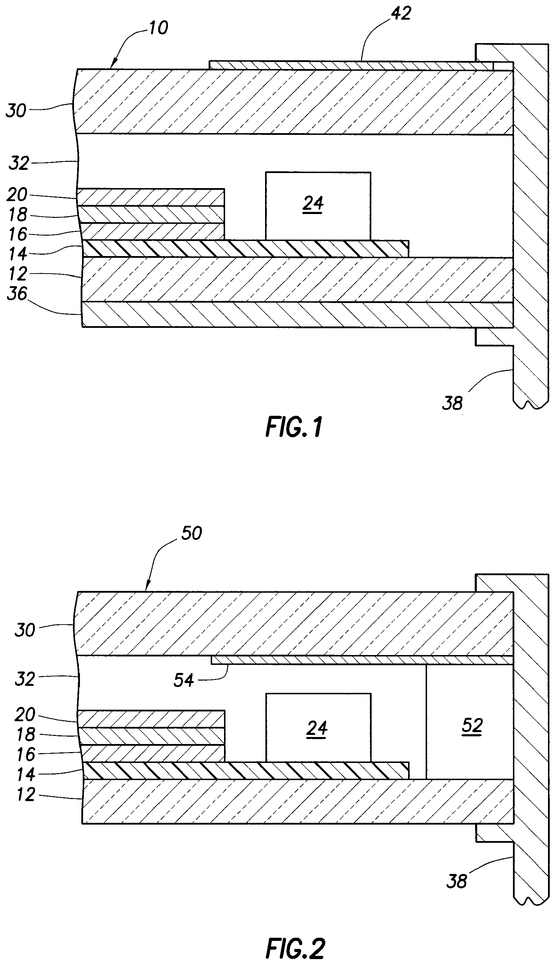

Reference is made to Figure 1 showing schematically a cross-section through the edge portion of a thin-film photovoltaic device 10 according to the present invention. The photovoltaic device 10 is supported on a substrate 12 which is typically glass of about 1 to 3 millimeters thickness. A back contact comprises a metal layer 14 deposited upon substrate 12. Layer 14, in the preferred embodiment, typically comprises or consists of molybdenum which has been deposited by sputtering to a thickness of about 0.2 to 2 microns. On top of the back electrode 14 a p-type chalkopyrite semiconductor layer 16 is arranged, having a thickness of about 0.2 to 2 microns.

A particular class of thin-film photovoltaic devices has an absorber layer formed of a group I-III-VI semiconductor, also referred to as a chalkopyrite semiconductor. Such a semiconductor is generally of the copper indium diselenide ("CIS") type, wherein this expression is to be understood such that indium can be partly or fully replaced by gallium and/or aluminium, and selenium can be partly or fully replaced by sulphur. CIS type semiconductors include those characterized by the formula CuInₓGa_{y}Al_{(1-x-y)}Se_{z}S_{(2-z)}, wherein x+y≤1 and z≤2. special cases of a CIS type layer are e.g. also denoted as CIGS or CIGSS. The CIS type layer can further comprise a low concentration, trace, or a doping concentration of one or more further elements or compounds, in particular alkali such as sodium, potassium, rubidium, cesium, and/or francium, or alkali compounds. The concentration of such further constituents is typically 5 wt% or less, preferably 3 wt% or less.

The CIS layer 16 can be formed by any method available in the art. A preferred method includes sputter deposition of a sequence of layers comprising the metal constituents of the CIS layer, optionally depositing a Se layer by vapour deposition, followed by rapid thermal processing. A preferred process is described in J. Palm, V. Probst and F. H. Karg, "Second generation CIS solar modules" Solar Energy, vol. 77, p. 757-765, 2004, incorporated by reference.

Between the layers 12 and 14 a diffusion barrier layer such as of silicon oxide or silicon nitride (not shown) can be arranged, which serves to suppress diffusion of alkali metals from the glass substrate into the CIS layer 16. Further, the CIS layer preferably contains a controlled amount of Na, as disclosed in USA patent No. 5,626, 688.

On top of the CIS type layer commonly a buffer layer 18 is arranged. The buffer layer can be e.g. of CdS, a Cd-free inorganic layer such as Zn(O,S) possibly also including hydroxide, but the buffer layer can also be omitted. It is also possible to arrange a layer of intrinsic ZnO, i.e. a ZnO layer that having a bulk resistivity higher than 1 Ohm.cm, preferably higher than 100 Ohm.cm, such as between 1 and 10 times 10³ Ohm.cm. Preferably the layer is between 10 nm and 150 nm thick.

The photovoltaic device 10 further comprises an n-type ZnO layer 20. The layer is appropriately doped to provide relatively low resistivity, for example, better than about 2.0 times 10⁻³ Ohm.cm, and preferably better than 1.0 times 10⁻³ Ohm.cm. The thickness of the layer 20 is suitably 0.5 to 2 microns.

Electrical connections of the layers are not shown in detail, but a conductor ribbon 24 is shown which is arranged to collect the current from the entire module and is connected or connectable to an electrical contact outside the module.

The stacked arrangement of the back electrode 14, CIS type layer 16, buffer layer 18 and ZnO front electrode 20 together forms the thin-film photovoltaic layer in this embodiment.

The photovoltaic device is covered by a cover plate, cover glass 30 of hardened glass, laminated to the substrate with the photovoltaic layer by means of a transparent polymer, such as EVA (ethylene vinyl acetate) or PVB (polyvinyl butyral), which fills the intermediate space and provides a seal at the circumference. It will be understood that the drawing is schematic and that the thickness of structures is not drawn to scale. At the rear side of the glass substrate in this embodiment a protecting layer of Tedlar/Polyester/Aluminium/Tedlar known as TPAT is arranged. Instead of a cover glass, cover plates of other materials can also be applied such as polymers that are transparent (above the photovoltaic layer).

A frame 38 holds and supports the photovoltaic device.

The cover glass 30 is at the light-receiving side of the photovoltaic device.

In accordance with the invention the cover glass 30, in an area adjacent to the photovoltaic layer, is opaque. This is achieved by coating 42 on the cover glass in a border area. The coating can be painted, screen printed and heated, but can also e.g. be a tape. For example a ceramic paste can be screen-printed and tempered. Instead of coating, also the body of the cover glass can be modified in the border area so as to be opaque, for example by adding a pigment or by inclusion of an opaque layer or substance. An embodiment in which an opaque coating is on the glass side facing the substrate will be discussed with reference to Figure 2. The coating or modification of the body of the cover plate 30 is provided prior to arranging the cover plate on the photovoltaic device. The coating is preferably nonconducting.

The opaque area extends from just above the photoactive part of the photovoltaic layer, essentially the edge of the CIS type layer 16, to below the rim of the frame 38. It is desirable to have the cover fully transparent over substantially the entire photoactive area, so that overlap of the opaque area, adjacent the transparent area of the cover, over the photoactive layer should be kept to a minimum. If there is no frame the opaque area suitably extends to the edge of the cover plate and can extend around the edge.

In this way the opaque area includes substantially all area that can receive light and under which area no photovoltaic layer is present.

The opaque area is suitably dark, preferably black. Preferably the opaque area also substantially blocks UV radiation. In this way degradation of polymer resin 32 in the edge area is retarded or suppressed.

Reference is now made to Figure 2, showing a second embodiment of a photovoltaic device 50 according to the invention. The devices are largely similar same reference numerals as in Figure 1 are used to refer to the same or similar parts, and we refer to the discussion thereof above. It is sufficient to discuss the differences with the embodiment of Figure 1. Along the edges of the photovoltaic device a polymeric sealant material in the form of a tape 52 is arranged. The edge seal may preferably comprise a moisture repellent material and/or a desiccant. Examples of suitable edge seal materials include butyl rubber, urethane and polyurethane materials, polyisobutylene materials, epoxide materials, polysulfamide materials; and cyanoacrylates. Such edge sealants may be applied in the form of a tape or strip prior to bringing the backside layer and the light-facing layer together.

The protecting layer 36 is not present on the rear side of the substrate.

The opaque area 54 is arranged as a coating on the inward-facing side of the glass cover 30. This is preferable because the coating itself is protected.

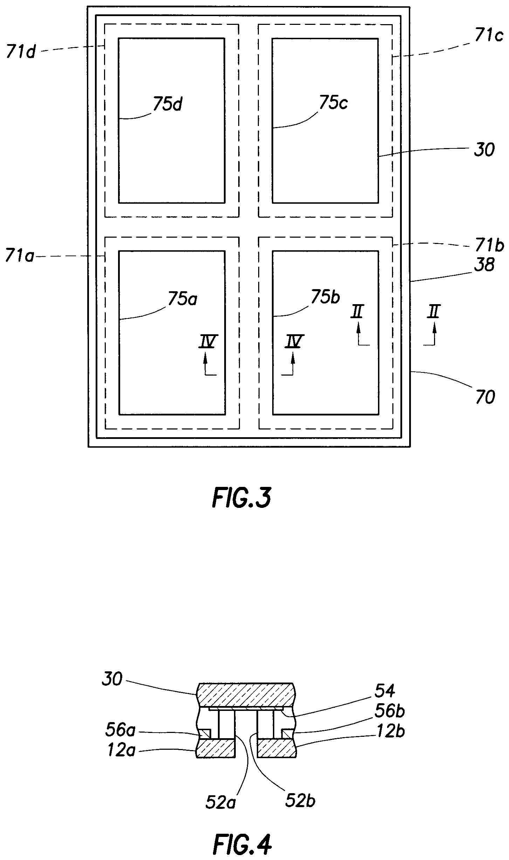

Reference is made to Figures 3 and 4, showing schematically a third embodiment of a photovoltaic device 70 according to the invention, in top view and in a cross-section along line IV-IV. Figure 3 shows a solar module formed of four solar cells 71a,b,c,d underneath a common cover glass 30 and in a common frame 38. The module is largely similar to the device 50 of Figure 2, in fact Figure 2 can be regarded as a cross-section along line II-II. In a module formed of a plurality of solar cells there can however be regions other than the circumference where the invention can be applied. In the cross-section of Figure 4 it is shown, that opaque area 54 can likewise be arranged in a central part of the photovoltaic device. The solid rectangles 75a,b,c,d in Figure 3 indicate the transparent area of the cover, and the remaining area of the cover glass that can receive light (such as outside the frame) is suitably all opaque. It shall be clear that Figures 3 and 4 are not to scale, the fraction of opaque area is exaggerated. The edge seals 52a, 52b and the area outside photovoltaic layers schematically shown as 56a,56b are shielded from light and UV.

The width of the area not covered by photoactive layer at the perimeter of the substrate is typically 1-2 cm, CIS layer is removed there in a processing step, e.g. by laser cleaning, in order to pass IEC qualification test branches like the wet leakage current test of IEC 61646. The final solar module when exposed to sunlight is highly absorbing in the active area of the circuit, but, without the present invention, is highly transparent at the film deleted zone at the perimeter. In consequence substrate and cover glass at the active area get heated up in the sun light and thermally expand, but the perimeter is not, or less, heated. In this way tensile stress is built up at the perimeter of the substrate, which is detrimental for fragile substrates and gives rise to high cracking probability. The likelihood for cracking of such type of substrate is expected to increase with the dimensions of the module substrate. The use of a cover according to the present invention overcomes this problem in that the opaque parts are also heated up such that no or much less tensile stress develops, and the cracking probability dramatically decreases.

The use of the cover according to the invention can also improve long time durability of solar modules by protecting polymeric sealant from degradation, especially due to UV. Examples of such material are the polymer 32 in the border area, and edge sealant 54, which are both adjacent the photovoltaic layer. Other examples are polymeric filler material or glue applied at the borders. Preferably the sealant is applied on the substrate before the cover is arranged thereupon. It has been found that such material can degrade and decompose under UV irradiation, and that this problem can be overcome by the present invention.

A further advantage of the invention is that certain module assembly components are aesthetically unattractive compared with the uniform black surface of a photovoltaic layer, such as a CIS type layer. These components include the circuit contact ribbons, the molybdenum-coated circuit contact zones, and solar edge tape as well as the transparent film-deleted circuit perimeter. The opaque area covers such components.

## Claims

1. A photovoltaic device (10) comprising a thin-film photovoltaic layer (16) between a substrate (12) and a cover plate (30), which cover plate (30) is transparent in an area above the photovoltaic layer (16), wherein the cover plate (30) overlaps the photovoltaic layer (16), and wherein the cover plate (30), in an area adjacent to the photovoltaic layer, is opaque, wherein the cover plate is coated in the opaque area, on at least one side facing towards, or away from, the substrate (12), or has a modified body so as to be opaque in that area, wherein the opaque area (42, 54) has a colour adjusted to the colour of the photovoltaic layer (16), wherein the opaque area extends from just above the edge of the photovoltaic layer (16) to the edge of the cover plate (30) or below the rim of a frame (38).

2. The photovoltaic device (10) according to claim 1, wherein the opaque area includes substantially all area that can receive light and under which area no photovoltaic layer is present.

3. The photovoltaic device (10) according to claims 1 or 2, wherein the cover plate (30) is a cover glass, preferably of hardened glass.

4. The photovoltaic device (10) according to any one of claims 1 through 3, wherein the substrate (12) is of unhardened glass.

5. The photovoltaic device (10) according to any one of claims 1 through 4, wherein the opaque area is black.

6. The photovoltaic device (10) according to any one of claims 1 through 5, wherein the opaque area also substantially blocks UV radiation.

7. The photovoltaic device (10) according to any one of claims 1 through 6, wherein a light degradable material (32, 52) is present between the substrate (12) and the cover glass (30), and wherein the cover is arranged such that the light degradable material (32, 52) is at least partially covered by the opaque area.

8. The photovoltaic device (10) according to any one of claims 1 through 7, wherein a polymeric sealant material (52) is present on the substrate (12), in particular along an edge of the substrate, and wherein the cover is arranged such that the polymeric sealant material (52) is covered by the opaque area.

9. Method of encapsulating a photovoltaic device (10), comprising the steps of
- providing a substrate (12) having an area with a thin-film photovoltaic layer (16) on a partial area of the substrate (12),
- providing a cover plate (30) having a transparent area and an opaque area adjacent the transparent area;
- arranging the cover plate (30) over the photovoltaic device, so that the opaque area covers at least part of the substrate area outside the partial area on which the photovoltaic device is arranged,
wherein the opaque area (42, 54) has a colour adjusted to the colour of the photovoltaic layer (16), wherein the opaque area extends from just above the edge of the photovoltaic layer (16) to the edge of the cover plate (30) or below the rim of a frame (38).

10. The method according to claim 9, wherein the cover plate (30) is provided, prior to arranging the cover over the substrate (12), with an opaque coating, or with a modified body so as to make the cover plate (30) opaque.

11. The method according to claim 9 or 10, further comprising the step of arranging a polymeric material (32, 52) between the substrate (30) and the cover plate (12).

12. The method according to claim 11, wherein the polymeric material is a polymeric sealant material (52) on the substrate (12); and wherein the cover plate (12) is arranged such that the polymeric sealant material (53) is covered by the opaque area.

## Patentansprüche

1. Eine photovoltaische Vorrichtung (10), umfassend eine dünne photovoltaische Schicht (16) zwischen einem Substrat (12) und einer Deckplatte (30), welche Deckplatte (30) in einem Bereich oberhalb der photovoltaischen Schicht (16) transparent ist, wobei die Deckplatte (30) die photovoltaische Schicht (16) überlappt, und wobei die Deckplatte (30) in einem an die photovoltaische Schicht angrenzenden Bereich opak ist, wobei die Deckplatte im opaken Bereich auf mindestens einer dem Substrat (12) zugewandten oder von diesem abgewandten Seite beschichtet ist, oder einen modifizierten Körper aufweist, um opak in diesem Bereich zu sein, wobei der opake Bereich (42, 54) eine Farbe aufweist, die an die Farbe der photovoltaischen Schicht (16) angepasst ist, wobei sich der opake Bereich von genau oberhalb des Rands der photovoltaischen Schicht (16) bis zum Rand der Deckplatte (30) oder unterhalb des Rands eines Rahmens (38) erstreckt.

2. Die photovoltaische Vorrichtung (10) nach Anspruch 1, wobei der opake Bereich im Wesentlichen den gesamten Bereich einschließt, der Licht aufnehmen kann und unter welchem Bereich keine photovoltaische Schicht vorhanden ist.

3. Die photovoltaische Vorrichtung (10) nach Anspruch 1 oder 2, wobei die Deckplatte (30) ein Deckglas ist, bevorzugt aus gehärtetem Glas.

4. Die photovoltaische Vorrichtung (10) nach einem der Ansprüche 1 bis 3, wobei das Substrat (12) aus ungehärtetem Glas besteht.

5. Die photovoltaische Vorrichtung (10) nach einem der Ansprüche 1 bis 4, wobei der opake Bereich schwarz ist.

6. Die photovoltaische Vorrichtung (10) nach einem der Ansprüche 1 bis 5, wobei der opake Bereich auch UV-Strahlung im Wesentlichen blockiert.

7. Die photovoltaische Vorrichtung (10) nach einem der Ansprüche 1 bis 6, wobei zwischen dem Substrat (12) und dem Deckglas (30) ein lichtabbaubares Material (32, 52) vorhanden ist, und wobei die Abdeckung derart angeordnet ist, dass das lichtabbaubare Material (32, 52) zumindest teilweise von dem opaken Bereich überdeckt ist.

8. Die photovoltaische Vorrichtung (10) nach einem der Ansprüche 1 bis 7, wobei auf dem Substrat (12) ein polymeres Dichtmaterial (52) vorhanden ist, insbesondere entlang einer Kante des Substrats, und wobei die Abdeckung derart angeordnet ist, dass das polymere Dichtungsmaterial (52) durch den opaken Bereich abgedeckt ist.

9. Verfahren zum Einkapseln einer photovoltaischen Vorrichtung (10), welches die Schritte umfasst:
- Bereitstellen eines Substrats (12) mit einem Bereich mit einer dünnen photovoltaischen Schicht (16) auf einem Teilbereich des Substrats (12),
- Bereitstellen einer Deckplatte (30) mit einem transparenten Bereich und einem an den transparenten Bereich angrenzenden opaken Bereich;
- Anordnen der Deckplatte (30) über der photovoltaischen Vorrichtung, so dass der opake Bereich zumindest einen Teil des Substratbereichs außerhalb des Teilbereichs, auf dem die photovoltaische Vorrichtung angeordnet ist, bedeckt,
wobei der opake Bereich (42, 54) eine Farbe aufweist, die an die Farbe der photovoltaischen Schicht (16) angepasst ist, wobei sich der opake Bereich von genau oberhalb des Rands der photovoltaischen Schicht (16) bis zum Rand der Deckplatte (30) oder unterhalb des Rands eines Rahmens (38) erstreckt.

10. Das Verfahren nach Anspruch 9, wobei die Deckplatte (30), vor dem Anordnen der Abdeckung über dem Substrat (12), mit einer opaken Beschichtung oder mit einem modifizierten Körper, um die Deckplatte (30) opak zu machen, versehen wird.

11. Das Verfahren nach Anspruch 9 oder 10, welches weiterhin den Schritt des Anordnens eines polymeren Materials (32, 52) zwischen dem Substrat (12) und der Abdeckplatte (30) umfasst.

12. Das Verfahren nach Anspruch 11, wobei das polymere Material ein polymeres Dichtungsmaterial (52) auf dem Substrat (12) ist; und wobei die Deckplatte (30) derart angeordnet ist, dass das polymere Dichtungsmaterial (53) von dem opaken Bereich bedeckt ist.

## Revendications

1. Un dispositif photovoltaïque (10) comprenant une couche photovoltaïque à couche mince (16) entre un substrat (12) et une plaque de recouvrement (30), laquelle plaque de couverture (30) est transparent dans une zone au-dessus de la couche photovoltaïque (16), où la plaque de recouvrement (30) chevauche la couche photovoltaïque (16), et où la plaque de recouvrement (30), dans une zone contiguë de à la couche photovoltaïque, est opaque, où la plaque de recouvrement est revêtue dans la zone opaque, sur au moins une face tournée vers ou à l'opposé du substrat (12), ou présente un corps modifié afin d'être opaque dans cette zone, où la zone opaque (42, 54) a une couleur ajustée à la couleur de la couche photovoltaïque (16), où la zone opaque s'étend de juste au-dessus du bord de la couche photovoltaïque (16) au bord de la plaque de recouvrement (30) ou au-dessous du rebord d'un cadre (38).

2. Le dispositif photovoltaïque (10) selon la revendication 1, où la zone opaque comprend essentiellement toute zone qui peut recevoir de la lumière et sous laquelle zone aucune couche photovoltaïque n'est présent.

3. Le dispositif photovoltaïque (10) selon les revendications 1 ou 2, où la plaque de recouvrement (30) est un verre de recouvrement, de préférence de verre trempé.

4. Le dispositif photovoltaïque (10) selon l'une quelconque des revendications 1 à 3, où le substrat (12) est de verre non trempé.

5. Le dispositif photovoltaïque (10) selon l'une quelconque des revendications 1 à 4, où la zone opaque est noire.

6. Le dispositif photovoltaïque (10) selon l'une des revendications 1 à 5, où la zone opaque bloque également substantiellement le rayonnement UV.

7. Le dispositif photovoltaïque (10) selon l'une quelconque des revendications 1 à 6, où un matériau dégradable à la lumière (32, 52) est présente entre le substrat (12) et le verre de recouvrement (30), et où la couverture est organisée de telle manière que la matière dégradable à la lumière (32, 52) est au moins en partie recouverte par la zone opaque.

8. Le dispositif photovoltaïque (10) selon l'une quelconque des revendications 1 à 7, où un matériau polymère d'étanchéité (52) est présent sur le substrat (12), en particulier le long du bord du substrat, et où la couverture est organisée de telle manière que le matériau polymère d'étanchéité (52) est recouvert par la zone opaque.

9. Méthode d'encapsulation d'un dispositif photovoltaïque (10), comprenant les étapes de
- fournir un substrat (12) ayant une zone avec une couche photovoltaïque à couche mince (16) sur une zone partielle du substrat (12),
- fournir une plaque de recouvrement (30) ayant une zone transparente et une zone opaque adjacente à la zone transparente ;
- disposer la plaque de recouvrement (30) sur le dispositif photovoltaïque, afin que la zone opaque couvre au moins une partie de la zone du substrat en dehors de la zone partielle sur laquelle le dispositif photovoltaïque est disposé,
où la zone opaque a une couleur ajustée à la couleur de la couche photovoltaïque (16), où la zone opaque s'étend de juste au-dessus du bord de la couche photovoltaïque (16) au bord de la plaque de recouvrement (30) ou au-dessous du rebord d'un cadre (38).

10. La méthode selon la revendication 9, où la plaque de recouvrement (30) est fournie, avant d'organiser la couverture sur le substrat (12), d'un revêtement opaque, ou d'un corps modifié afin de rendre la plaque de recouvrement (30) opaque.

11. La méthode selon l'une des revendications 9 ou 10, comprenant en outre l'étape de disposer un matériau polymère (32, 52) entre le substrat (12) et la plaque de recouvrement (30).

12. La méthode selon la revendication 11, où le matériau polymère est un matériau polymère d'étanchéité (52) sur le substrat (12) ; et où la plaque de recouvrement (30) est disposée tel que le matériau polymère d'étanchéité (53) est recouvert par la zone opaque.
